# EUROPEAN PATENT APPLICATION

(11) **EP 2 204 848 A1**
(43) Date of publication of application: **07.07.2010**
(21) Application number: 09180851.9
(22) Date of filing: 29.12.2009
(51) Int. Cl.: H01L 23/498, H01L 23/00, H01L 23/50

(54) **Semiconductor Package and Plasma Display Device including the same**

(30) Priority: 31.12.2008 KR 20080138245; 11.12.2009 US 654171
(71) Applicant: Samsung SDI Co., Ltd., Gyeonggi-do (KR)
(72) Inventor: KIM, Dae-Young, Gyeonggi-do (KR)
(74) Representative: Gulde Hengelhaupt Ziebig & Schneider

(57) **Abstract**

Provided are a semiconductor package and a plasma display device including the same. The semiconductor package includes: a film substrate that relays a signal between a circuit board and a display panel; a semiconductor chip that is electrically connected to the film substrate; a reinforcement plate to which the film substrate and the semiconductor chip are directly attached, and that provides a floating ground; and a connecting member that electrically connects the reinforcement plate and a ground of the semiconductor chip, and the reinforcement plate and a ground of the film substrate. Accordingly, the semiconductor package has excellent heat dissipation performance and ground stability.

## Description

### BACKGROUND OF THE INVENTION

### 1. Field of the Invention

The present invention relates to a semiconductor package and a plasma display device including the same, and more particularly, to a semiconductor package with excellent heat dissipation performance and ground stability, and a plasma display device including the same.

### 2. Description of the Related Art

Semiconductor packages are becoming miniaturized and highly integrated, and structures of the semiconductor packages are being variously changed according to improved performance of semiconductor chips included in the semiconductor packages. A conventional chip on film (COF) semiconductor package denotes a package in which at least one semiconductor chip is attached to a flexible substrate having a film shape and on which a signal wire is formed. Such COF semiconductor packages are widely used because of their flexibility, have a simple structure since a printed circuit board (PCB) is not required, are lightweight, thin, and inexpensive, and are suitable for fine pitch between leads.

A COF semiconductor package may be used in a plasma display device. Generally, a plasma display device realizes a predetermined image via gas discharge, and includes, for example, a plurality of display cells arranged in a matrix pattern, a plurality of discharge electrodes generating discharge in the display cells. Also, the COF semiconductor package may be disposed between the display panel and a circuit board constituting a signal generator, so as to change a driving signal and relay a signal. However, display panel structures are now becoming highly detailed and precise, and specifically, the number of display cells is remarkably increasing as display panels are developed to a full-high definition (HD) level. Accordingly, the throughput of the COF semiconductor package remarkably increases in proportion to the number of electrodes assigned to each display cell, and thus heat dissipation for preventing deterioration is required. Moreover, many circuit units are used in order to obtain a high level of accuracy and multi-functionality, and thus a new package structure that can withstand external noise and is stably grounded is required.

In the following, if a first element is said to be directly attached to a second element, the first element may directly contact the second element, or a third element, e.g. an adhesive element, may be disposed between the first element and the second element to attach the first element to the second element, but no further elements serving other functions than to attach the first element to the second element are disposed between the first element and the second element.

### SUMMARY OF THE INVENTION

The present invention provides a semiconductor package with excellent heat dissipation performance and ground stability, and a plasma display device including the same.

According to an aspect of the present invention, there is provided a semiconductor package including: a film substrate that relays a signal between a circuit board and a display panel; a semiconductor chip that is electrically connected to the film substrate; a reinforcement plate to which the film substrate and the semiconductor chip are directly attached, and that provides a floating ground; and a connecting member that electrically connects the reinforcement plate and a ground of the semiconductor chip, and the reinforcement plate and a ground of the film substrate.

The semiconductor chip may be attached to the reinforcement plate by disposing a conductive adhesive layer between the semiconductor chip and the reinforcement plate.

The connecting member may include a conductive wire or bond wire or a conductive bump.

The film substrate may have a stacked structure of a base film attached to the reinforcement plate, a conductive pattern disposed on the base film, and a cover-ray embedding the conductive pattern.

The reinforcement plate may include a metal plate that is thicker than the conductive pattern.

According to another aspect of the present invention, there is provided a plasma display device including: a plasma display panel that realizes an image via gas discharge; at least one circuit board that generates a driving signal of the plasma display panel; a semiconductor package that includes a film substrate that relays a signal between the at least one circuit board and the plasma display panel, a semiconductor chip that is electrically connected to the film substrate, a reinforcement plate to which the film substrate and the semiconductor chip are directly attached, and that provides a floating ground, and a connecting member that electrically connects the reinforcement plate and a ground of the semiconductor chip, and the reinforcement plate and a ground of the film substrate; and a chassis that comprises at least one first combining boss for installing the semiconductor package, wherein the at least one first combining boss protrudes from the chassis.

The semiconductor chip may be directly attached to the reinforcement plate by disposing a conductive adhesive layer between the semiconductor chip and the reinforcement plate.

The connecting member may include a bond wire or a conductive bump.

The film substrate may have a stacked structure of a base film attached to the reinforcement plate, a conductive pattern disposed on the base film, and a cover-ray embedding the conductive pattern.

The reinforcement plate may include a metal plate that is thicker than the conductive pattern.

The plasma display device may further include at least one first connecting hole for location fixation formed in the reinforcement plate, and a first combining member penetrating the at least one first connecting hole and combined to the at least one first combining boss.

The plasma display panel may further include at least one second connecting hole for location fixation formed in the circuit board, a second combining boss protruding from the chassis at a location aligned with the at least one second connecting hole, and a second combining member penetrating the at least one second connecting hole and combined to the second combining boss.

The plasma display device may further include a connector connected to a terminal of the film substrate, wherein the connector is formed on the circuit board.

According to yet another aspect of the present invention, there is provided a method of fabricating a semiconductor package, the method comprising the steps of forming a film substrate for relaying a signal between a circuit board and a display panel, electrically connecting a semiconductor chip to the film substrate, directly attaching the film substrate and the semiconductor chip to a reinforcement plate for providing a floating ground, and forming a connecting member to electrically connect the reinforcement plate and a ground of the semiconductor chip, and the reinforcement plate and a ground of the film substrate.

Directly attaching the semiconductor chip to the reinforcement plate may comprise forming a conductive adhesive layer between the semiconductor chip and the reinforcement plate. Forming the connecting member may comprise forming a conductive wire or bond wire or forming a conductive bump. Forming the film substrate may comprises forming a base film attached to the reinforcement plate, forming a conductive pattern on the base film, and forming a cover-ray to embed the conductive pattern. The reinforcement plate may comprise a metal plate that is thicker than the conductive pattern.

### BRIEF DESCRIPTION OF THE DRAWINGS

The above and other features and advantages of the present invention will become more apparent by describing in detail exemplary embodiments thereof with reference to the attached drawings in which:
FIG. 1 is a plan view of a chip on film (COF) substrate included in a semiconductor package, according to an embodiment of the present invention;
FIG. 2 is a plan view of a semiconductor package including the COF substrate of FIG. 1, according to an embodiment of the present invention;
FIG. 3 is a perpendicular cross-sectional view of the semiconductor package of FIG. 2 taken along the line III-III' of FIG. 2;
FIG. 4 is a perpendicular cross-sectional view of a semiconductor package according to Comparative Example 1;
FIG. 5 is a perpendicular cross-sectional view of a semiconductor package according to Comparative Example 2; and
FIG. 6 is an exploded perspective view of a plasma display device according to an embodiment of the present invention.

### DETAILED DESCRIPTION OF THE INVENTION

Hereinafter, the present invention will be described more fully with reference to the accompanying drawings, in which exemplary embodiments of the invention are shown.

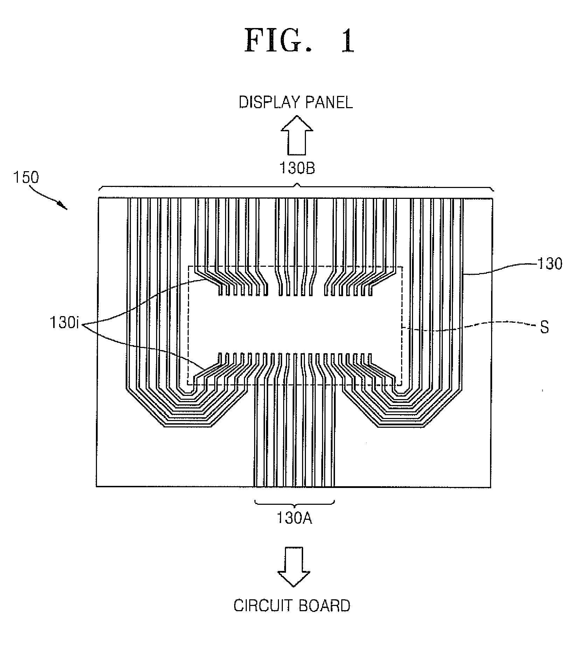

FIG. 1 is a plan view of a chip on film (COF) substrate 150 included in a semiconductor package, according to an embodiment of the present invention. A semiconductor chip (not shown) is mounted at a location S indicated by a dotted line on the COF substrate 150, thereby forming a COF semiconductor package. The COF substrate 150, for example, is disposed between a circuit board constituting a signal generator and a display panel, and changes and relays a signal. In detail, a plurality of conductive patterns 130 extend in opposite directions from the location S. In this regard, the conductive patterns 130 extending in a first direction form an array of input wires 130A receiving a signal from the circuit board, and the conductive patterns 130 extending in a second direction form an array of output wires 130B transmitting the signal to the display panel. For each of the conductive patterns 130, an inner lead 130i leading out of the location S along said conductive pattern 130 is electrically connected to a respective one of a plurality of electrodes of the semiconductor chip via wire bonding or conductive bump bonding. This will be described later in more detail. The inner leads 130i may be closely arranged on the location S in an integrated form and may have a micro-scale pitch.

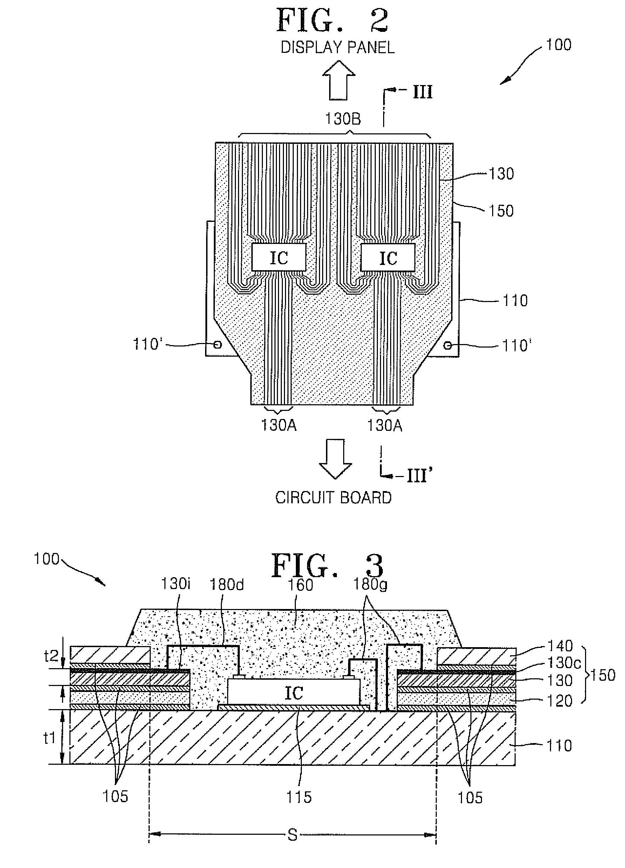

FIG. 2 is a plan view of a semiconductor package 100 including the COF substrate 150 of FIG. 1, according to an embodiment of the present invention. Referring to FIG. 2, the semiconductor package 100 according to the present embodiment includes at least two semiconductor chips IC disposed parallel to each other, and a reinforcement plate 110 to which the COF substrate 150 providing input and output wires of the semiconductor chips IC is attached. The reinforcement plate 110 structurally supports the COF substrate 150, and specifically in the present invention, provides a floating ground of the semiconductor chips IC while operating as a heat dissipation plate of the semiconductor chips IC, Such functions of the reinforcement plate 110 will be described in detail later. Meanwhile, a connecting hole 110' may be formed in at least one corner of the reinforcement plate 110, and the semiconductor package 100 may be fixed by using a screw (not shown) combined to a chassis (not shown) through the connecting hole 110'.

FIG. 3 is a perpendicular cross-sectional view of the semiconductor package 100 of FIG. 2 taken along the line II1-III' of FIG. 2. Referring to FIG. 3, the semiconductor package 100 includes the reinforcement plate 110 providing structural support, the COF substrate 150 disposed on the reinforcement plate 110, and the semiconductor chip IC directly mounted on the reinforcement plate 110 and electrically connected to the COF substrate 150. The COF substrate 150 may have a multi-layered structure in which a plurality of thin layers are stacked. In detail, the COF substrate 150 includes a base film 120 that is insulative and disposed on the reinforcement plate 110, the conductive patterns 130 disposed on the base film 120, and a cover-ray 140 protecting the conductive patterns 130 by embedding the conductive patterns 130. The base film 120 may be formed of a polymer resin material, such as polyimide having fine electric insulation and flexibility. The conductive patterns 130 disposed on the base film 120 are electrically connected to an integrated circuit of the semiconductor chip IC via inner leads 130i of the conductive patterns 130, and electrically connected to the circuit board and the display panel via the input and output wires 130A and 130B of FIG. 2 extending in opposite directions of the semiconductor chip IC. The conductive patterns 130 may be formed of a metal having good electrical conductivity, and for example may be a copper foil on which a tinning layer 130c is formed so as to prevent corrosion. The base film 120 and the cover-ray 140 may be respectively attached to bottom and top surfaces of the conductive patterns 130 so as to provide an electrical insulative environment, while preventing the conductive patterns 130 from being mechanically damaged or disconnected due to an external shock. Each of the inner leads 130i of the conductive patterns 130 may be connected to an electrode pad exposed on the semiconductor chip IC via a bond wire 180d hanging in a suspension state (wire bonding), and may transmit a data signal via the bond wire 180d. In the current embodiment, an interconnection between the inner lead 130i and the semiconductor chip IC is formed via wire bonding, but alternatively, the inner lead 130i and the semiconductor chip IC may be electrically connected by disposing a conductive bump (not shown) between the inner lead 130i and the semiconductor chip IC. Such connection is known as conductive bump bonding. Meanwhile, the cover-ray 140 may be formed of an insulative polymer material, such as a solder resist, and may embed a portion of the conductive pattern 130 excluding a bonding portion with the semiconductor chip IC. The base film 120, the conductive patterns 130, and the cover-ray 140 that form the multi-layered structure of the COF substrate 150 may be combined with each other via adhesive layers 105 disposed therebetween.

The reinforcement plate 110 provides structural strength to the entire semiconductor package 100, while operating as a heat dissipation plate of the semiconductor chip IC. The semiconductor chip IC generates a large amount of heat during operation, and has a suitable heat dissipation structure by being thermally connected with the reinforcement plate 110. As illustrated in FIG. 3, the semiconductor chip IC is attached to one side of the reinforcement plate 110 by disposing a conductive adhesive layer 115 between the semiconductor chip IC and the reinforcement plate 110, and thus the heat generated in the semiconductor chip IC during operation is directly transmitted to the reinforcement plate 110, and the heat transmitted to the reinforcement plate 110 is dissipated by convection to the outside via an external surface of the reinforcement plate 110. Accordingly, the temperature of the semiconductor chip IC is maintained within a suitable range during operation, and malfunction due to heat may be prevented. The conductive adhesive layer 115 combining the semiconductor chip IC and the reinforcement plate 110 may be a silver (Ag) paste having good thermal conductivity.

The reinforcement plate 110 performs a heat dissipation function by being thermally combined with the semiconductor chip IC, while providing a ground area of the entire semiconductor package 100. In detail, the reinforcement plate 110 is connected to a ground electrode of the semiconductor chip IC via a ground wire 180g, while being connected to the conductive pattern 130 via another ground wire 180g. However, the present invention is not limited to this connection structure, and as described above, the reinforcement plate 110 may be connected to the ground electrode of the semiconductor chip IC and the conductive pattern 130 by conductive bump bonding. Accordingly, a common ground potential between the semiconductor chip IC and the conductive pattern 130 is maintained by using the reinforcement plate 110 providing a ground. The ground provided by the conductive pattern 130 may be a floating ground limitedly shared within the semiconductor package 100, and for example, a ground shared by a circuit network including an external circuit such as the display panel or the circuit board may be provided by a frame structure, such as the chassis, providing a wide ground area. The reinforcement plate 110 may be formed of a metal conductor having a predetermined volume or more, so as to maintain heat capacity sufficient for heat dissipation and simultaneously maintain electrical capacity sufficient in terms of stability of a ground voltage. Here, a thickness t1 of the reinforcement plate 110 may be greater than a thickness t2 of the conductive patterns 130 (t1 > t2).

Meanwhile, the semiconductor chip IC and the COF substrate 150 attached to the reinforcement plate 110 are sealed by a molding resin 160 such as epoxy molding composite (EMC), so as to form the integrated semiconductor package 100. The molding resin 150 seals the semiconductor chip IC, and a bonding area between the semiconductor chip IC and the inner leads 130i, and insulates and protects the sealed portion from the external environment.

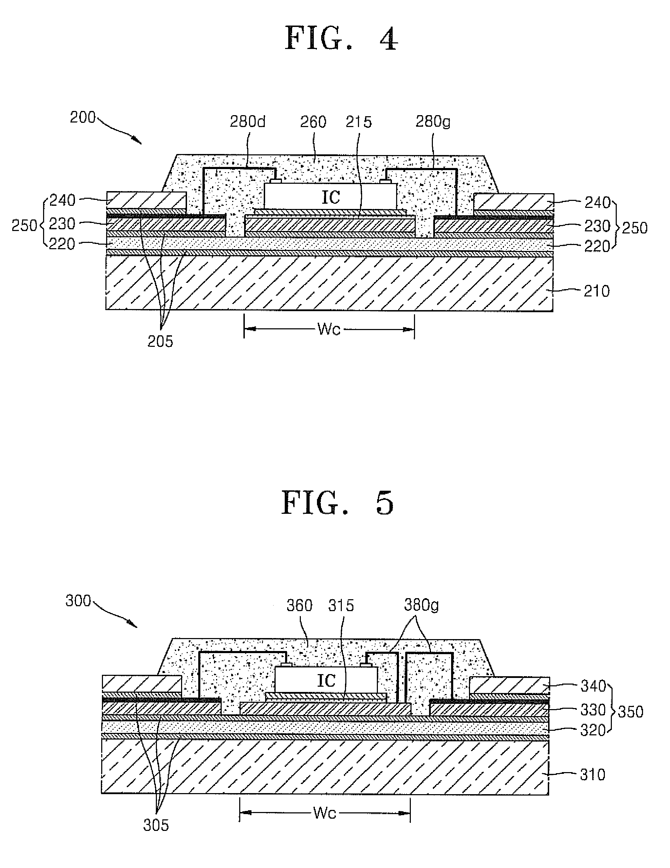

FIG. 4 is a perpendicular cross-sectional view of a semiconductor package 200 according to Comparative Example 1. Referring to FIG. 4, the semiconductor package 200 uses a reinforcement plate 210 as a supporting structure, on which a film substrate 250 is disposed, and a semiconductor chip IC is mounted on the film substrate 250. In this regard, the film substrate 250 has a stacked structure including a base film 220, a conductive pattern 230, and a cover-ray 240, which are combined with each other by using adhesive layers 205 disposed therebetween. The semiconductor chip IC is electrically connected to the conductive pattern 230 by using a bond wire 280d. The semiconductor chip IC communicates a time-varying data signal via the bond wire 280d, while receiving a ground signal of a uniform ground level via a ground wire 280g.

The semiconductor chip IC is not directly mounted on the reinforcement plate 210, but mounted on the film substrate 250. In other words, the semiconductor chip IC is mounted on a mounting area We in a center of the film substrate 250 by disposing an adhesive layer 215 between the semiconductor chip IC and the film substrate 250. Also, heat generated in the semiconductor chip IC during operation is transmitted to the reinforcement plate 210 via a heat dissipation path on the film substrate 250, and thus a heat dissipation effect is remarkably low. Specifically, the film substrate 250 including the heat dissipation path basically has a multi-layered structure, and thus thermal contact resistance between the layers is relatively high. Moreover, the film substrate 250 inevitably includes a material having a thermal insulative characteristic, for example, an insulation material such as the adhesive layer 205 or the base film 220, and thus heat dissipation is delayed and a heat dissipation effect decreases. By contrast, in the semiconductor package 100 of FIG. 3 according to an embodiment of the present invention, the semiconductor chip IC is directly mounted on the reinforcement plate 110, and thus direct thermal combination is possible, and the heat generated in the semiconductor chip IC during operation is quickly transmitted to the reinforcement plate 110. Accordingly, a heat dissipating effect is remarkably increased.

Meanwhile, in Comparative Example 1, the reinforcement plate 210 only operates as a heat dissipation plate of the semiconductor chip IC, and does not have a ground function providing a reference potential. In detail, the semiconductor chip IC is connected and grounded to an external ground area (not shown) via the ground wire 280g. A ground line of the semiconductor chip IC extends to the external ground area along the conductive pattern 130, and as a length of the ground line increases, resistance of the ground line increases. Moreover, electromagnetic interference (EMI) components generated by an external circuit element are mixed with noise elements, and thus the semiconductor package 200 is susceptible to noise. By contrast, in the semiconductor package 100 of FIG. 3 according to an embodiment of the present invention, the semiconductor chip IC is directly grounded with respect to the reinforcement plate 110, and thus a length of a ground line is decreased, and thus a strong and stable ground potential with respect to an external environment may be provided. Meanwhile, reference number 260 in FIG. 4 denotes a molding resin that seals and integrates the semiconductor chip IC and the film substrate 250 disposed on the reinforcement plate 210.

FIG. 5 is a perpendicular cross-sectional view of a semiconductor package 300 according to Comparative Example 2. In FIG. 5, a film substrate 350 is disposed on a reinforcement plate 310, and a semiconductor chip IC is mounted on the film substrate 350. In this regard, the film substrate 350 has a multi-layered structure including a base film 320, a conductive pattern 330, and a cover-ray 340, which are combined with each other via adhesive layers 305 disposed therebetween. In FIG. 5, a mounting area Wc on which the semiconductor chip IC is mounted is used as a ground, and thus the semiconductor chip IC is grounded by using the mounting area Wc. In other words, the semiconductor chip IC and the conductive pattern 330 are electrically connected to the mounting area Wc by a bonding wire 380g, so as to maintain a common ground potential. However, the ground potential may change, considering that the conductive pattern 330 providing the mounting area Wc generally has a thin copper foil pattern and thus is unable to provide sufficient electrical capacity, and the conductive pattern 330 having a minute pitch therebetween is susceptible to electromagnetic interference or external noise. In the semiconductor package 100 of FIG. 3 according to an embodiment of the present invention, the reinforcement plate 110 providing ground potential may have a large area for structural stability of the entire semiconductor package 100, may have sufficient thermal capacity considering a heat dissipation characteristic, and may have a predetermined volume or more so as to have sufficient electrical capacity, and thus the semiconductor package 100 may stably provide a uniform reference potential. Meanwhile, reference numeral 315 of FIG. 5 denotes an adhesive layer for fixing the semiconductor chip IC to the mounting area Wc, and reference numeral 360 denotes a sealing resin that integrates the semiconductor chip IC and the film substrate 350 to the semiconductor package 300 by sealing the semiconductor chip IC and the film substrate 350.

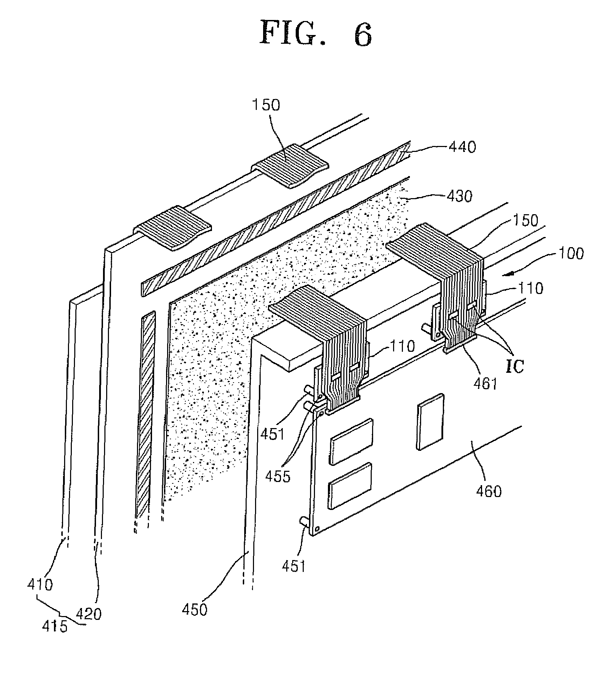

FIG. 6 is an exploded perspective view of a plasma display device including the semiconductor package 100, according to an embodiment of the present invention. Referring to FIG. 6, the plasma display device according to the present embodiment includes a plasma display panel 415 realizing a predetermined image by using gas discharge, a chassis 450 structurally supporting the plasma display panel 415 and supporting a plurality of circuit boards 460 for driving the plasma display panel, and the semiconductor package 100 for relaying and changing a signal between the circuit boards 460 and the plasma display panel 415. The plasma display panel 415 includes a front panel 410 and a rear panel 420 that are combined to face each other. The front panel 410 and/or the rear panel 420 includes barrier ribs (not shown) for defining a plurality of discharge cells (not shown), and a plurality of discharge electrodes (not shown) for generating discharge in each discharge cell. Terminals of the discharge electrodes are connected to the COF substrate 150, so that a suitable driving signal can be applied to the discharge electrodes.

The chassis 450 structurally supports the plasma display panel 415 that is susceptible to external shock, and operates as a heat dissipation plate of the plasma display panel 415 in which discharge heat is accumulated. Also, the chassis 450 provides installation surfaces of the circuit boards 460 and the semiconductor package 100 for driving the plasma display panel 415, and accordingly, a plurality of combining bosses 451 may protrude from a rear surface of the chassis 450. The plasma display panel 415 and the chassis 460 may be combined with each other with predetermined pressure by disposing a thermal conductive sheet 430 and an adhesive tape 440 therebetween.

The semiconductor package 100 includes at least one semiconductor chip IC, the COF substrate 150 providing wires of the at least one semiconductor chip IC, and the reinforcement plate 110 to which the at least one semiconductor chip IC and the COF substrate 150 are attached and which provides an installation structure. The semiconductor package 100 may be fixed to the chassis 450, as a screw 455 inserted into a combining hole formed on a corner of the reinforcement plate 110 is screwed into the combining boss 451 protruding from the chassis 450. Similarly, a connecting hole for location fixation may be formed on a corner of the circuit board 460, and the circuit board 460 may be fixed to the chassis 450 as the screw 455 inserted into the connecting hole is screwed into the combining boss 451 protruding from the chassis 450. The semiconductor package 100, specifically the semiconductor chip IC, is electrically connected to a connector 461 formed on the circuit board 460, converts an input signal from the circuit board 460 into a suitable driving signal, and provides the driving signal to the plasma display panel 415. The detailed structure of the semiconductor package 100 has been described with reference to FIGS. 1 through 3, and thus descriptions thereof will not be repeated.

According to the present invention, a semiconductor chip is directly mounted on a reinforcement plate, and thus the semiconductor chip and the reinforcement plate are directly thermally combined with each other, and heat generated in the semiconductor chip during operation is quickly transmitted to the reinforcement plate. Accordingly, a heat dissipation effect is remarkably increased, and deterioration of the semiconductor chip is prevented.

Also, in the present invention, the semiconductor chip is directly grounded to the reinforcement plate, and thus a length of a ground line can be decreased. Accordingly, a voltage change due to ground line resistance is prevented, and noise, such as EMI, generated by an external circuit element is prevented, and thus ground stability is increased.

## Claims

1. A semiconductor package (100) comprising:
a substrate (150) that is adapted to relay a signal between a circuit board (460) and a display panel (415);
a semiconductor chip (IC) that is electrically connected to the substrate (150);
a reinforcement plate (110) to which the substrate (150) and the semiconductor chip (IC) are directly attached, and that is adapted to provide a floating ground; and
a connecting member (180g) that electrically connects the reinforcement plate (110) and a ground of the semiconductor chip (IC), and the reinforcement plate (110) and a ground of the substrate (150).

2. The semiconductor package (100) of claim 1, wherein the semiconductor chip (IC) is attached to the reinforcement plate (110) by a conductive adhesive layer (115) disposed between the semiconductor chip (IC) and the reinforcement plate (110).

3. The semiconductor package (100) of any one of the preceding claims, wherein the connecting member (180g) comprises a bond wire (180g) or a conductive bump.

4. The semiconductor package (100) of any one of the preceding claims, wherein the substrate (150) has a stacked structure of a base film (120) attached to the reinforcement plate (110), a conductive pattern (130) disposed on the base film (120), and a cover-ray (140) embedding the conductive pattern (130).

5. The semiconductor package (100) of claim 4, wherein the reinforcement plate (110) comprises a metal plate that is thicker than the conductive pattern (130).

6. The semiconductor package (100) of any one of the preceding claims, wherein the substrate (150) is a film substrate.

7. A plasma display device comprising:
a plasma display panel (415) that is adapted to realize an image via gas discharge;
at least one circuit board (460) that is adapted to generate a driving signal of the plasma display panel (415);
a semiconductor package (100) according to any one of the preceding claims;
and
a chassis (450) that comprises at least one first combining boss (451) for installing the semiconductor package (100), wherein the at least one first combining boss (451) protrudes from the chassis (450).

8. The plasma display device of claim 7, further comprising at least one first connecting hole (110') for location fixation formed in the reinforcement plate (110), and a first combining member (455) penetrating the at least one first connecting hole (110') and combined to the at least one first combining boss (451).

9. The plasma display panel (415) of any one of claims 7 to 8, further comprising at least one second connecting hole for location fixation formed in the circuit board (460), a second combining boss (451) protruding from the chassis (450) at a location aligned with the at least one second connecting hole, and a second combining member (455) penetrating the at least one second connecting hole and combined to the second combining boss (451).

10. The plasma display device of any one of claims 7 to 9, further comprising a connector (461) connected to a terminal of the substrate (150), wherein the connector (461) is formed on the circuit board (460).

11. A method of fabricating a semiconductor package (100), the method comprising the steps of:
forming a substrate (150) for relaying a signal between a circuit board (460) and a display panel (415);
electrically connecting a semiconductor chip (IC) to the substrate (150);
directly attaching the substrate (150) and the semiconductor chip (IC) to a reinforcement plate (110) for providing a floating ground; and
forming a connecting member (180g) to electrically connect the reinforcement plate (110) and a ground of the semiconductor chip (IC), and the reinforcement plate (110) and a ground of the substrate (150).

12. The method of claim 11, wherein directly attaching the semiconductor chip (IC) to the reinforcement plate (110) comprises forming a conductive adhesive layer (115) between the semiconductor chip (IC) and the reinforcement plate (110).

13. The method of any one of claims 11 to 12, wherein forming the connecting member (180g) comprises forming a bond wire (180g) or forming a conductive bump.

14. The method of any one of claims 11 to 13, wherein forming the substrate (150) comprises:
forming a base film (120) attached to the reinforcement plate (110);
forming a conductive pattern (130) on the base film (120); and
forming a cover-ray (140) to embed the conductive pattern (130).

15. The method of claim 14, wherein the reinforcement plate (110) comprises a metal plate that is thicker than the conductive pattern (130).

16. The method of any one of claims 11 to 15, wherein the substrate (150) is a film substrate.
